# EUROPEAN PATENT APPLICATION

(11) **EP 4 071 840 A1**
(43) Date of publication of application: **12.10.2022**
(21) Application number: 20897175.4
(22) Date of filing: 01.12.2020
(51) Int. Cl.: H01L 51/44

(54) **LIGHT ABSORPTION LAYER, METHOD FOR MANUFACTURING SAME, DISPERSION LIQUID, PHOTOELECTRIC CONVERSION ELEMENT, AND SOLAR CELL**

(30) Priority: 02.12.2019 WO PCT/JP2019/047062
(71) Applicant: Kao Corporation, Chuo-ku Tokyo 103-8210 (JP)
(72) Inventor: OGOMI,Yuhei, Wakayama-shi, Wakayama 640-8580 (JP)
(74) Representative: Hoffmann Eitle
(86) International application number: PCT/JP2020/044650
(87) International publication number: WO 2021/112072

(57) **Abstract**

The present invention provides a light absorption layer for forming a photoelectric conversion element and a solar cell excellent in photoelectric conversion efficiency, a photoelectric conversion element and a solar cell having the light absorption layer, and a method for manufacturing a light absorption layer having few voids. The light absorption layer of the present invention contains a perovskite compound and a quantum dot containing an aliphatic amino acid.

## Description

### TECHNICAL FIELD

The present invention relates to a light absorption layer and a method for manufacturing the light absorption layer, a dispersion for manufacturing the light absorption layer, a photoelectric conversion element having the light absorption layer, and a solar cell having the photoelectric conversion element.

### BACKGROUND ART

A photoelectric conversion element that converts light energy into electric energy is used for solar cells, optical sensors, copying machines, and the like. In particular, from the viewpoint of environmental and energy problems, photoelectric conversion elements (solar cells) utilizing sunlight that is an inexhaustible clean energy attract attention.

Since general silicon solar cells utilize ultra-high purity silicon and are manufactured by "dry process" such as epitaxial crystal growth under high vacuum, it is not possible to expect a large cost reduction. Therefore, a solar cell manufactured by a "wet process" such as a coating process is expected as a low-cost next generation solar cell.

A quantum dot solar cell is a next-generation solar cell that can be manufactured by the "wet process". The quantum dot is an inorganic nanoparticle having a particle size of about 20 nm or less and a crystal structure, and exhibits physical properties different from those of bulk bodies due to the expression of quantum size effect. For example, it is known that the band gap energy increases (shortening of the absorption wavelength) as the particle size of quantum dots decreases, and lead sulfide (PbS) quantum dots having a particle size of about 3 nm and a band gap energy of about 1.2 eV have been reported for use in quantum dot solar cells (ACS Nano 2014, 8, 614-622). A quantum dot solar cell, typical examples thereof including PbS or PbSe quantum dot, can attain photoelectric conversion in a near-infrared light region (800 to 2500 nm). However, the band gap energy thereof is small so that the solar cell cannot gain a high voltage to be low in conversion efficiency.

There is a perovskite solar cell as the most promising candidate for the next generation solar cell, which has been recently reported to show a rapid increase in photoelectric conversion efficiency. This perovskite solar cell is provided with a photoelectric conversion element using a perovskite compound (CH₃NH₃PbI₃) composed of a cation (such as methyl ammonium) and a halogenated metal salt (such as lead iodide) for the light absorption layer (J. Am. Chem. Soc. 2009, 131, 6050-6051). The perovskite solar cell can attain photoelectric conversion in a visible light region (400 to 800 nm) and shows a relatively high conversion efficiency. However, the perovskite solar cell cannot utilize a near-infrared light region to be insufficient in effective utilization of sunlight.

In recent years, A quantum dot solar cell has been reported which make use of PbS quantum dots surface-treated with a perovskite compound (CH₃NH₃PbI₃) in a light absorption layer (Nano Lett. 2015, 15, 7539-7543). However, the perovskite compound is small in quantity so that the compound hardly contributes to power generation. Thus, the solar cell is insufficient in conversion efficiency.

In addition, there has been proposed a light absorption layer for forming a photoelectric conversion element and a solar cell which can attain photoelectric conversion in both a visible light region and a near-infrared light region and which are high in conversion efficiency, the light absorption layer containing a perovskite compound and a quantum dot containing a Cl element (WO 2018/163325).

Furthermore, there has been proposed a light absorption layer for forming a photoelectric conversion element and a solar cell which can attain photoelectric conversion in both a visible light region and a near-infrared light region and which are high in conversion efficiency, the light absorption layer containing a perovskite compound and a quantum dot containing a halogen element and an organic ligand, wherein a molar ratio of the organic ligand to a metal element constituting the quantum dot is 0.01 or more and 0.4 or less (WO 2018/163327).

### SUMMARY OF THE INVENTION

In order to improve the photoelectric conversion efficiency of a solar cell using a light absorption layer containing a perovskite compound and a quantum dot, it is necessary to improve the quantum yield. Examples of the method for improving the quantum yield include a method of filling the light absorption layer with quantum dot at a high density. However, when the content of the quantum dot in the light absorption layer is increased, a large number of voids are generated in the light absorption layer accordingly, or the coverage of the light absorption layer is reduced, resulting in a problem that the quantum yield is reduced.

The present invention relates to a light absorption layer for forming a photoelectric conversion element and a solar cell excellent in photoelectric conversion efficiency, and a photoelectric conversion element and a solar cell having the light absorption layer. The present invention also relates to a method for manufacturing a light absorption layer having few voids.

The present inventor has found that a light absorption layer comprising a perovskite compound and a quantum dot containing an aliphatic amino acid has few voids, and the photoelectric conversion efficiency of a solar cell is improved by using the light absorption layer.

That is, the present invention is related to a light absorption layer comprising a perovskite compound, and a quantum dot containing an aliphatic amino acid.

In addition, the present invention is related to a dispersion comprising:
a perovskite compound or a precursor thereof; and
a quantum dot containing an aliphatic amino acid.

Moreover, the present invention is related to a method for manufacturing a light absorption layer in which a quantum dot containing an aliphatic amino acid is dispersed in a matrix of a perovskite compound, the method comprising following steps 1, 2, and 3 :
(step 1) a step of exchanging the organic ligand of the quantum dot containing the organic ligand with an aliphatic amino acid to obtain a quantum dot solid containing an aliphatic amino acid as a ligand;
(step 2) a step of mixing the quantum dot solid obtained in step 1 with a solution or a mixed liquid containing one or more types of substances selected from a perovskite compound and a precursor thereof to obtain a dispersion; and
(step 3) a step of obtaining a light absorption layer from the dispersion obtained in step 2.

The use of the perovskite compound and the quantum dot containing an aliphatic amino acid as a material for forming the light absorption layer makes it possible to absorb light in a wide wavelength region including not only light in a short wavelength region, which can be absorbed by the perovskite compound, but also light in a long wavelength region such as a near-infrared light region, which can be absorbed by the quantum dot. This makes is possible to obtain a photoelectric conversion element having a photoelectric conversion function in a wide wavelength region.

In addition, as compared with the case of using the conventional quantum dot, when the quantum dot containing an aliphatic amino acid is used, the photoelectric conversion efficiency of the light absorption layer (composite film) containing the perovskite compound and the quantum dot is improved. The reason thereof is not clear, but is presumed as follows.

An amino group as a polar group present on a surface of the quantum dot interacts with a polar solvent (for example, N,N-dimethylformamide) in a dispersion for manufacturing a light absorption layer. This interaction improves compatibility between the quantum dot and the polar solvent and prevents aggregation of the quantum dots due to electrostatic repulsion between the amino groups, thereby improving the dispersibility of the quantum dot in the dispersion. As a result, a light absorption layer having few voids, and further a light absorption layer having fewer voids, high crystallinity of the perovskite compound (large crystallite diameter), and high coverage can be obtained. Thus, the photoelectric conversion efficiency of the light absorption layer is improved.

Therefore, when the light absorption layer of the present invention is used, a photoelectric conversion element and a solar cell excellent in photoelectric conversion efficiency can be obtained.

### BRIEF DESCRIPTION OF THE DRAWINGS

Fig. 1 is a schematic cross-sectional view showing an example of the structure of a photoelectric conversion element of the present invention.
Fig. 2 is a cross-sectional SEM image of a light absorption layer prepared in Example 2.
Fig. 3 is a cross-sectional SEM image of a light absorption layer prepared in Comparative Example 1.
Fig. 4 is a schematic view illustrating a solid in which a quantum dot and a perovskite compound are combined in the light absorption layer prepared in Example 2.
Fig. 5 is a schematic view illustrating a solid in which a quantum dot and a perovskite compound are combined and voids in the solid in the light absorption layer prepared in Comparative Example 1.

### BRIEF DESCRIPTION OF THE DRAWINGS

### <Light Absorption Layer>

The light absorption layer of the present invention includes, as a light absorption agent, a perovskite compound, and a quantum dot containing an aliphatic amino acid. The light absorption layer of the present invention may include any light absorption agent other than the above-mentioned light absorption agent as long as the advantageous effects of the present invention are not damaged.

The light absorption layer of the present invention may have an intermediate band. The intermediate band is an energy level formed by the interaction between the quantum dots in the band gap of the perovskite compound. The intermediate band is present at an energy position near the lower end of the conduction band and/or near the upper end of the valence band of the quantum dot. The intermediate band is formed, for example, by regularly arranging quantum dots in a matrix of the perovskite compound at a high density. When the intermediate band is present in the band gap of the perovskite compound, for example, two-step photon absorption occurs in which an electron photoexcited from the valence band of the perovskite compound to the intermediate band is further photoexcited from the intermediate band to the conduction band of the perovskite compound. Therefore, the presence of the intermediate band can be confirmed by measuring the quantum yield of the two-step photon absorption, that is, difference in the external quantum yield.

The perovskite compound is preferably one or more kinds selected from a compound represented by the following general formula (1) and a compound represented by the following general formula (2), more preferably a compound represented by the following general formula (1) from the viewpoint of improving photoelectric conversion efficiency.

RMX₃ (1)

(R is a monovalent cation, M is a divalent metal cation, and X is a halogen anion.)

   R¹R²R³ₙ₋₁MₙX₃ₙ₊₁ (2)
(R¹, R² and R³ are each independently a monovalent cation, M is a divalent metal cation, X is a halogen anion, and n is an integer of 1 to 10.)
R is a monovalent cation, and examples thereof include a cation of a first group element of the periodic table and an organic cation. R is preferably an organic cation from the viewpoint of improving photoelectric conversion efficiency. Examples of the cation of the group 1 of the periodic table include Li⁺, Na⁺, K⁺, and Cs⁺. Examples of the organic cation include an ammonium ion which may have a substituent and a phosphonium ion which may have a substituent. Examples of the optionally substituted ammonium ion include an alkylammonium ion, a formamidinium ion and an arylammonium ion, and from the viewpoint of improving photoelectric conversion efficiency, the optionally substituted ammonium ion is preferably one or more kinds selected from an alkyl ammonium ion and a formamidinium ion, more preferably one or more kinds selected from a monoalkylammonium ion and a formamidinium ion, still more preferably one or more kinds selected from a methylammonium ion, an ethylammonium ion, a butylammonium ion and a formamidinium ion, and even still more preferably a methylammonium ion.

Each of R¹, R², and R³ mentioned above is independently a monovalent cation, and any or all of R¹, R², and R³ may be the same. For example, examples of the monovalent cation include a cation of the group 1 of the periodic table and an organic cation. Examples of the cation of the group 1 of the periodic table include Li⁺, Na⁺, K⁺, and Cs⁺. Examples of the organic cation include an ammonium ion which may have a substituent and a phosphonium ion which may have a substituent. Examples of the optionally substituted ammonium ion include an alkylammonium ion, a formamidinium ion and an arylammonium ion, and from the viewpoint of improving durability and photoelectric conversion efficiency, the optionally substituted ammonium ion is preferably one or more kinds selected from an alkyl ammonium ion and a formamidinium ion, more preferably a monoalkylammonium ion, still more preferably one or more kinds selected from a methylammonium ion, an ethylammonium ion, a butylammonium ion, a hexylammonium ion, an octylammonium ion, a decylammonium ion, a dodecyl ammonium ion, a tetradecyl ammonium ion, a hexadecyl ammonium ion, and an octadecyl ammonium ion.

The n is an integer of 1 to 10 and from the viewpoint of improving durability and photoelectric conversion efficiency, n is preferably 1 to 4.

The M is a divalent metal cation and includes, for example, Pb²⁺, Sn²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺, and Eu²⁺. From the viewpoint of excellent durability (moisture resistance) and photoelectric conversion efficiency, the M is preferably Pb²⁺, Sn²⁺, or Ge²⁺, more preferably Pb²⁺ or Sn²⁺, still more preferably Pb²⁺.

The X is a halogen anion, and examples thereof include a fluorine anion, a chlorine anion, a bromine anion, and an iodine anion. In order to obtain a perovskite compound having a desired band gap energy, the X is preferably a fluorine anion, a chlorine anion or a bromine anion, more preferably a chlorine anion or a bromine anion, still more preferably a bromine anion.

From the viewpoint of improving photoelectric conversion efficiency, the perovskite compound is preferably a perovskite compound having a band gap energy of 1.5 eV or more and 4.0 eV or less. The perovskite compound may be used alone, or two or more perovskite compounds different in band gap energy may be used.

From the viewpoint of improving photoelectric conversion efficiency (voltage), the band gap energy of the perovskite compound is preferably 1.7 eV or more, more preferably 2.0 eV or more, still more preferably 2.1 eV or more, even still more preferably 2.2 eV or more, and from the viewpoint of improving photoelectric conversion efficiency (current), the band gap energy of the perovskite compound is preferably 3.6 eV or less, more preferably 3.0 eV or less, still more preferably 2.4 eV or less. The band gap energies of the perovskite compound and the quantum dot can be determined from the absorption spectrum measured at 25°C by the method described in Examples described later. The wavelength corresponding to the band gap energy determined from the absorption spectrum is called an absorption edge wavelength.

Examples of the compound represented by the general formula (1) having a band gap energy of 1.5 eV or more and 4.0 eV or less include CH₃NH₃PbCl₃, CH₃NH₃PbBr₃, CH₃NH₃PbI₃, CH₃NH₃PbBrI₂, CH₃NH₃PbBr₂I, CH₃NH₃SnCl₃, CH₃NH₃SnBr₃, CH₃NH₃SnI₃, CH(=NH)NH₃PbCl₃, and CH(=NH)NH₃PbBr₃. Among these, from the viewpoint of improving durability and photoelectric conversion efficiency, CH₃NH₃PbBr₃ and CH(=NH)NH₃PbBr₃ are preferable and CH₃NH₃PbBr₃ is more preferable.

Examples of the compound represented by the general formula (2) having a band gap energy of 1.5 eV or more and 4.0 eV or less include (C₄H₉NH₃)₂PbI₄, (C₆H₁₃NH₃)₂PbI₄, (C₈H₁₇NH₃)₂PbI₄, (C₁₀H₂₁NH₃)₂PbI₄, (C₁₂H₂₅NH₃)₂PbI₄, (C₄H₉NH₃)₂(CH₃NH₃)Pb₂I₇, (C₆H₁₃NH₃)₂(CH₃NH₃)Pb₂I₇, (C₈H₁₇NH₃)₂(CH₃NH₃)Pb₂I₇, (C₁₀H₂₁NH₃)₂(CH₃NH₃)Pb₂I₇, (C₁₂H₂₅NH₃)₂(CH₃NH₃)Pb₂I₇, (C₄H₉NH₃)₂(CH₃NH₃)₂Pb₃I₁₀, (C₆H₁₃NH₃)₂(CH₃NH₃)₂Pb₃I₁₀, (C₈H₁₇NH₃)₂(CH₃NH₃)₂Pb₃I₁₀, (C₁₀H₂₁NH₃)₂(CH₃NH₃)₂Pb₃I₁₀, (C₁₂H₂₅NH₃)₂(CH₃NH₃)₂Pb₃I₁₀, (C₄H₉NH₃)₂PbBr₄, (C₆H₁₃NH₃)₂PbBr₄, (C₈H₁₇NH₃)₂PbBr₄, (C₁₀H₂₁NH₃)₂PbBr₄, (C₄H₉NH₃)₂(CH₃NH₃)Pb₂Br₇, (C₆H₁₃NH₃)₂(CH₃NH₃)Pb₂Br₇, (C₈H₁₇NH₃)₂(CH₃NH₃)Pb₂Br₇, (C₁₀H₂₁NH₃)₂(CH₃NH₃)Pb₂Br₇, (C₁₂H₂₅NH₃)₂(CH₃NH₃)Pb₂Br₇, (C₄H₉NH₃)₂(CH₃NH₃)₂Pb₃Br₁₀, (C₆H₁₃NH₃)₂(CH₃NH₃)₂Pb₃Br₁₀, (C₈H₁₇NH₃)₂(CH₃NH₃)₂Pb₃Br₁₀, (C₁₀H₂₁NH₃)₂(CH₃NH₃)₂Pb₃Br₁₀, (C₁₂H₂₅NH₃)₂(CH₃NH₃)₂Pb₃Br₁₀, (C₄H₉NH₃)₂(CH₃NH₃)₂Pb₃Cl₁₀, (C₆H₁₃NH₃)₂(CH₃NH₃)₂Pb₃Cl₁₀, (C₈H₁₇NH₃)₂(CH₃NH₃)₂Pb₃Cl₁₀, (C₁₀H₂₁NH₃)₂(CH₃NH₃)₂Pb₃Cl₁₀, and (C₁₂H₂₅NH₃)₂(CH₃NH₃)₂Pb₃Cl₁₀.

The crystallite diameter of the perovskite compound of the light absorption layer is preferably 10 nm or more, more preferably 20 nm or more, still more preferably 30 nm or more, and still more preferably 40 nm or more, from the viewpoint of improving carrier transfer efficiency and improving photoelectric conversion efficiency. The crystallite diameter of the perovskite compound is preferably 1,000 nm or less from the same viewpoint.

The perovskite compound can be produced, for example, from a perovskite compound precursor as described later. As a precursor of the perovskite compound, for example, in the case where the perovskite compound is a compound represented by the general formula (1), a combination of a compound represented by MX₂ and a compound represented by RX can be mentioned. Also, in the case where the perovskite compound is a compound represented by the general formula (2), a combination of a compound represented by MX₂ with one or more kinds selected from a compound represented by R¹X, a compound represented by R²X, and a compound represented by R³X can be mentioned.

The perovskite compound in the light absorption layer can be identified by the conventional methods such as element analysis, infrared (IR) spectrum, Raman spectrum, nuclear magnetic resonance (NMR) spectrum, X-ray diffraction pattern, absorption spectrum, emission spectrum, electron microscope observation, and electron beam diffraction.

The quantum dot containing an aliphatic amino acid is a quantum dot containing an aliphatic amino acid in addition to the component constituting the crystal structure, and the state of the aliphatic amino acid is not particularly limited. The quantum dot is preferably a compound in which an aliphatic amino acid is coordinated to the surface of the quantum dot (a compound in which an aliphatic amino acid is coordinated to a metal element constituting the quantum dot). Other ligands may be coordinated to the surface of the quantum dot together with the aliphatic amino acid. Hereinafter, unless otherwise specified, preferred embodiments of the quantum dot containing an aliphatic amino acid are preferred embodiments common to the light absorption layer and the raw material thereof except for preferred embodiments of ligands other than the aliphatic amino acid.

Examples of the quantum dot containing an aliphatic amino acid include compounds containing a metal oxide or a metal chalcogenide (for example, sulfides, selenides, and tellurides). A compound in which an aliphatic amino acid is coordinated to the surface of a metal oxide or a metal chalcogenide is preferable from the viewpoint of excellent photoelectric conversion efficiency. From the viewpoint of improving photoelectric conversion efficiency, preferred is a compound in which the aliphatic amino acid is coordinated to the surface of the metal chalcogenide. Examples of the metal chalcogenide include PbS, PbSe, PbTe, CdS, CdSe, CdTe, Sb₂S₃, Bi₂S₃, Ag₂S, Ag₂Se, Ag₂Te, Au₂S, Au₂Se, Au₂Te, Cu₂S, Cu₂Se, Cu₂Te, Fe₂S, Fe₂Se, Fe₂Te, In₂S₃, SnS, SnSe, SnTe, CuInS₂, CuInSe₂, CuInTe₂, EuS, EuSe, and EuTe. From the viewpoint of excellent photoelectric conversion efficiency, the quantum dot containing the aliphatic amino acid preferably contains Pb element, more preferably PbS or PbSe, still more preferably PbS. In order to increase the interaction between the perovskite compound and the quantum dot, the metal constituting the perovskite compound and the metal constituting the quantum dot are preferably the same metal.

The aliphatic amino acid may be a linear amino acid or a branched amino acid. In the present invention, the linear amino acid refers to an aliphatic amino acid having a linear carbon chain structure, and the branched amino acid refers to an aliphatic amino acid having a branched carbon chain structure. The aliphatic amino acid is preferably a linear amino acid from the viewpoint of facilitating coordination of the aliphatic amino acid to the surface of the quantum dot and improving the dispersibility of the quantum dot in the light absorption layer and the dispersion.

The number of carbon atoms of the aliphatic amino acid is preferably 10 or less, more preferably 8 or less, and still more preferably 7 or less, from the viewpoint of improving the carrier transfer speed in the light absorption layer to improve photoelectric conversion efficiency and from the viewpoint of decreasing the distance between the quantum dots to disperse the quantum dots in the matrix of the perovskite compound at a high density. The number of carbon atoms of the aliphatic amino acid is preferably 2 or more, and more preferably 3 or more, from the viewpoint of ensuring the dispersibility of the quantum dot in the coating solution.

The amino group of the aliphatic amino acid may be bonded to any carbon in the carbon chain. The amino group of the aliphatic amino acid is preferably bonded to a primary carbon from the viewpoint of facilitating coordination of the aliphatic amino acid to the surface of the quantum dot to improve the dispersibility of the quantum dot in the light absorption layer and the dispersion.

From the viewpoint of complementing the band gap energy which the perovskite compound does not have and improving the photoelectric conversion efficiency of the light absorption layer in the near-infrared light region, the band gap energy of the quantum dot containing the aliphatic amino acid is preferably 0.2 eV or more and equal to or less than the band gap energy of the perovskite compound. The quantum dot containing the aliphatic amino acid may be used singly or in combination of two or more kinds having different band gap energies. When two or more kinds of perovskite compounds having different band gap energies are used, "the band gap energy equal to or less than the band gap energy of the perovskite compound", which is the upper limit of the band gap energy of the quantum dot containing the aliphatic amino acid, means a band gap energy equal to or less than the maximum value of the band gap energy of two or more kinds of perovskite compounds. The band gap energy of the quantum dot can be determined from the absorption spectrum measured at 25°C by the method described in Examples described later.

From the viewpoint of improving photoelectric conversion efficiency (voltage), the band gap energy of the quantum dot containing the aliphatic amino acid is preferably 0.7 eV or more, more preferably 0.8 eV or more, still more preferably 0.9 eV or more, even still more preferably 1.0 eV or more, and from the viewpoint of improving photoelectric conversion efficiency (current), the band gap energy of the quantum dot containing the aliphatic amino acid is preferably 1.6 eV or less, more preferably 1.5 eV or less, still more preferably 1.4 eV or less.

The difference between the band gap energy of the perovskite compound and the band gap energy of the quantum dot containing the aliphatic amino acid is preferably 0.4 eV or more, more preferably 0.6 eV or more, still more preferably 0.8 eV or more, and preferably 2.0 eV or less, more preferably 1.5 eV or less, still more preferably 1.3 eV or less, from the viewpoint of improving photoelectric conversion efficiency.

For example, when the particle size and the type of the quantum dot are determined by electron microscope observation, electron beam diffraction, X-ray diffraction pattern, or the like, the band gap energy of the quantum dot can also be calculated from the correlation between the particle size and the band gap energy (for example, ACS Nano 2014, 8, 6363-6371).

As the method for coordinating the aliphatic amino acid to the surface of the quantum dot, for example, a quantum dot in which the aliphatic amino acid is coordinated to the surface thereof can be prepared by core formation and crystal growth of the quantum dot in the presence of the aliphatic amino acid.

The quantum dots of the light absorption layer can be identified, for example, by element analysis, infrared (IR) spectrum, Raman spectrum, nuclear magnetic resonance (NMR) spectrum, X-ray diffraction pattern, absorption spectrum, emission spectrum, small angle X-ray scattering, electron microscopic observation, electron beam diffraction, and the like.

Examples of the method for verifying that the quantum dot contains the aliphatic amino acid include a method of observing a change in the dispersibility of the quantum dot in an organic solvent, and a method of detecting the aliphatic amino acid through thermal analyses such as thermogravimetry-differential thermal analysis (TG-DTA), a nuclear magnetic resonance (NMR) method, and spectroscopies such as an infrared (IR) method.

The quantum dot may contain an organic ligand such as a carboxy group-containing compound other than the aliphatic amino acid, an amino group-containing compound other than the aliphatic amino acid, a thiol group-containing compound, and a phosphino group-containing compound, and an inorganic ligand such as a halogen element-containing substance, from the viewpoint of dispersibility in the light absorption layer and the dispersion, ease of manufacturing, cost, expression of excellent performance, and the like.

Examples of the carboxy group-containing compound other than the aliphatic amino acid include oleic acid, stearic acid, palmitic acid, myristic acid, lauric acid, and capric acid.

Examples of the amino group-containing compound other than the aliphatic amino acid include oleylamine, stearylamine, palmitylamine, myristylamine, laurylamine, caprylamine, octylamine, hexylamine, butylamine and the like.

Examples of the thiol group-containing compound include ethanethiol, ethanedithiol, benzenethiol, benzenedithiol, decanethiol, decanedithiol, mercaptopropionic acid, and the like.

Examples of the phosphino group-containing compound include trioctylphosphine, tributylphosphine, and the like.

The organic ligand is preferably the carboxy group-containing compound or the amino group-containing compound, more preferably the carboxy group-containing compound, still more preferably a carboxylic acid, still more preferably a fatty acid, still more preferably a fatty acid having 8 or more and 30 or less carbon atoms, still more preferably a fatty acid having 12 or more and 18 or less carbon atoms, still more preferably an unsaturated fatty acid having 12 or more and 18 or less carbon atoms, and still more preferably oleic acid, from the viewpoint of ease of manufacturing, dispersion stability, versatility, cost, expression of excellent performance, and the like of the quantum dot.

Examples of the halogen element of the halogen element-containing substance include fluorine, chlorine, bromine, and iodine.

Examples of the halogen element-containing substance include iodine, ammonium iodide, and methylammonium iodide.

A preferable combination of the perovskite compound and the quantum dot containing an aliphatic amino acid is preferably a combination of compounds containing the same metal element and/or a combination of compounds containing a nitrogen-containing functional group (for example, an ammonium group and an amino group), from the viewpoint of uniform dispersibility of the quantum dot, durability of the light absorption layer, and photoelectric conversion efficiency. Examples thereof include a combination of CH₃NH₃PbBr₃ and PbS in which the aliphatic amino acid is coordinated; a combination of CH₃NH₃PbBr₃ and PbSe in which the aliphatic amino acid is coordinated; a combination of CH₃NH₃PbI₃ and PbS in which the aliphatic amino acid is coordinated; a combination of CH₃NH₃PbI₃ and PbSe in which the aliphatic amino acid is coordinated; a combination of CH(=NH)NH₃PbBr₃ and PbS in which the aliphatic amino acid is coordinated; and a combination of CH(=NH)NH₃PbBr₃ and PbSe in which the aliphatic amino acid is coordinated. A combination of CH₃NH₃PbBr₃ and PbS in which the aliphatic amino acid is coordinated is more preferable.

The content of the quantum dot in the light absorption layer is preferably 7.5% by mass or more, more preferably 10% by mass or more, and still more preferably 12% by mass or more, from the viewpoint of filling the quantum dot at a high density to reduce the distance between the quantum dots and allowing the quantum dots to interact with each other to form an intermediate band in the light absorption layer, and improving the quantum yield of the two-step photon absorption. The content is preferably 40% by mass or less, more preferably 30% by mass or less, still more preferably 25% by mass or less, and still more preferably 20% by mass or less, from the viewpoint of suppressing film-forming property and carrier transfer from the perovskite compound to the quantum dot to improve photoelectric conversion efficiency.

The porosity of the light absorption layer is preferably 10% or less, more preferably 8% or less, still more preferably 5% or less, and still more preferably 0%, from the viewpoint of improving photoelectric conversion efficiency. In the present invention, the porosity refers to the proportion of voids in a solid in which the perovskite compound and the quantum dot are combined. The porosity is specifically measured by the method described in Examples. Note that, in a case where the porosity of the light absorption layer is 10% or less, the distance between the quantum dots is a distance necessary for forming the intermediate band, and thus, it is considered that the interaction between the quantum dots increases. Therefore, it is considered that the quantum yield of the two-step absorption is significantly improved.

The thickness of the light absorption layer is preferably 30 nm or more, more preferably 50 nm or more, and still more preferably 80 nm or more, from the viewpoint of increasing light absorption to improve photoelectric conversion efficiency. The thickness is preferably 1,000 nm or less, more preferably 800 nm or less, still more preferably 600 nm or less, and still more preferably 500 nm or less, from the viewpoint of improving carrier transfer efficiency to the hole transport material layer or the electron transport material layer to improve photoelectric conversion efficiency. The thickness of the light absorption layer can be measured by a measuring method such as electron microscope observation of the cross section of the film.

From the viewpoint of improving the strength of a hole transport material (HTM) layer, the surface smoothness of the light absorption layer is preferably 100 nm or more, more preferably 200 nm or more, still more preferably 300 nm or more, even still more preferably 400 nm or more, and from the viewpoint of improving photoelectric conversion efficiency, the surface smoothness of the light absorption layer is preferably 1000 nm or less, more preferably 800 nm or less, still more preferably 700 nm or less.

The coverage of the light absorption layer to the functional layer (for example, porous layer) is preferably 80% or more, more preferably 90% or more, still more preferably 95% or more, even still more preferably 100%, from the viewpoint of improving photoelectric conversion efficiency (current), and is 100% or less. The coverage of the light absorption layer to the functional layer (for example, porous layer) can be measured by the method described in the following Examples.

### <Method for manufacturing light absorption layer>

Preferable examples of the method for manufacturing the light absorption layer include a method based on a so-called wet process in which a dispersion containing a perovskite compound and/or a precursor thereof and a quantum dot containing an aliphatic amino acid is applied onto a substrate and dried. From the viewpoint of ease of manufacturing, cost, storage stability of the dispersion, improvement of photoelectric conversion efficiency, and the like, a manufacturing method including following steps 1, 2, and 3 is preferable:
(step 1) a step of exchanging the organic ligand of the quantum dot containing the organic ligand with an aliphatic amino acid to obtain a quantum dot solid containing an aliphatic amino acid as a ligand;
(step 2) a step of mixing the quantum dot solid obtained in step 1 with a solution or a mixed liquid containing one or more types of substances selected from a perovskite compound and a precursor thereof to obtain a dispersion; and
(step 3) a step of obtaining a light absorption layer from the dispersion obtained in step 2.

The step (step 1) of exchanging the organic ligand of the quantum dot containing the organic ligand with an aliphatic amino acid to obtain a quantum dot solid containing the aliphatic amino acid as a ligand is preferable, from the viewpoint of improving the dispersibility of the dispersion containing the perovskite compound and/or the precursor thereof and the quantum dot, and from the viewpoint of improving carrier transfer speed in the light absorption layer to improve photoelectric conversion efficiency.

In general, the quantum dot may be synthesized using a hydrophobic compound having a relatively large molecular size, such as oleic acid, as a ligand in order to control the particle size, suppress aggregation, improvement of dispersibility, and the like of the quantum dot. In this case, the quantum dot exhibits excellent dispersibility in a non-(low) polar organic solvent such as toluene, but exhibits poor dispersibility in a polar organic solvent such as N,N-dimethylformamide or methanol. Therefore, when a solvent for dispersing or dissolving the perovskite compound and/or the precursor thereof is a polar organic solvent, it is necessary to disperse the quantum dots in the polar organic solvent, and it is preferable to coordinate a substance having high compatibility with the polar organic solvent to the quantum dot. In addition, a hydrophobic compound having a relatively large molecular size, such as oleic acid has low conductivity and inhibits diffusion of carriers in the light absorption layer. It is therefore preferable to coordinate a substance having a relatively small molecular size to the quantum dot, from the viewpoint of improving carrier transfer speed in the light absorption layer to improve photoelectric conversion efficiency. From the above viewpoint, the ligand of the quantum dot is preferably an aliphatic amino acid having 2 to 10 carbon atoms, more preferably an aliphatic amino acid having 3 to 8 carbon atoms, and still more preferably an aliphatic amino acid having 3 to 7 carbon atoms.

As a method for exchanging the organic ligand of the quantum dot containing an organic ligand with an aliphatic amino acid, a method for exchanging the ligand in a dispersion is preferable from the viewpoint of ease of manufacturing, cost, storage stability of the dispersion, improvement of photoelectric conversion efficiency, and the like. Also, a method for exchanging the ligand by mixing a quantum dot dispersion containing the organic ligand and a solution containing the aliphatic amino acid at room temperature (25°C) without stirring over time and then allowing the mixture to stand is more preferable.

The mixing amount of the aliphatic amino acid used for ligand exchange is preferably 0.1 or more, more preferably 1 or more, still more preferably 1.5 or more, and preferably 10 or less, more preferably 8 or less, still more preferably 5 or less, and still more preferably 3 or less as the molar ratio of the aliphatic amino acid to the organic ligand on the surface of the quantum dot, from the viewpoint of ease of manufacturing, cost, storage stability of the dispersion, improvement of photoelectric conversion efficiency, and the like.

The solvent used for ligand exchange is preferably a mixed solvent of a solvent in which the quantum dots are well dispersed and a solvent in which the aliphatic amino acid is dissolved, from the viewpoint of ease of manufacturing, cost, storage stability of the dispersion, improvement of photoelectric conversion efficiency, and the like. The dispersion solvent of the quantum dot is preferably one or more types of non-(low) polar organic solvents selected from toluene, hexane, octane, and the like, and is more preferably toluene. The solvent for dissolving the aliphatic amino acid is preferably one or more types of aprotic polar organic solvents selected from N,N-dimethylformamide, dimethyl sulfoxide, γ-butyrolactone, and the like, and is more preferably N,N-dimethylformamide.

The solid content concentration of the quantum dot to be mixed in the quantum dot dispersion at the time of ligand exchange is preferably 10 mg/mL or more, more preferably 50 mg/mL or more, still more preferably 80 mg/mL or more, and preferably 1,000 mg/mL or less, more preferably 500 mg/mL or less, still more preferably 200 mg/mL or less, still more preferably 120 mg/mL or less, from the viewpoint of ease of manufacturing, cost, storage stability of the dispersion, improvement of photoelectric conversion efficiency, and the like.

The concentration of the aliphatic amino acid to be mixed in the aliphatic amino acid solution at the time of ligand exchange is preferably 0.01 mol/L or more, more preferably 0.1 mol/L or more, still more preferably 0.2 mol/L or more, and preferably 1 mol/L or less, more preferably 0.5 mol/L or less, still more preferably 0.3 mol/L or less, from the viewpoint of ease of manufacturing, cost, storage stability of the dispersion, improvement of photoelectric conversion efficiency, and the like.

The method for mixing the quantum dot dispersion and the aliphatic amino acid solution at the time of ligand exchange is not particularly limited as long as it is a method for mixing these solutions over time without stirring. The method is preferably a continuous method or a dropping method (semi-continuous method), and more preferably a dropping method, from the viewpoint of ease of manufacturing, cost, storage stability of the dispersion, improvement of photoelectric conversion efficiency, and the like.

The continuous method may be a method of mixing the aliphatic amino acid solution in the quantum dot dispersion, or a method of mixing the quantum dot dispersion in the aliphatic amino acid solution. The continuous method is preferably a method of mixing the aliphatic amino acid solution in the quantum dot dispersion, from the viewpoint of ease of manufacturing, cost, storage stability of the dispersion, improvement of photoelectric conversion efficiency, and the like. The mixing rate is preferably 25 µL/sec or less, more preferably 5 µL/sec or less, still more preferably 3 µL/sec or less, and preferably 0.2 µL/sec or more, more preferably 0.4 µL/sec or more, still more preferably 1.5 µL/sec or more, from the viewpoint of ease of manufacturing, cost, storage stability of the dispersion, improvement of photoelectric conversion efficiency, and the like.

The dropping method may be a method of dropping the aliphatic amino acid solution into the quantum dot dispersion, or a method of dropping the quantum dot dispersion into the aliphatic amino acid solution. The dropping method is preferably a method of dropping the aliphatic amino acid solution into the quantum dot dispersion, from the viewpoint of ease of manufacturing, cost, storage stability of the dispersion, improvement of photoelectric conversion efficiency, and the like. The dropping rate is preferably 1 drop/1 sec or less, more preferably 1 drop/5 sec or less, still more preferably 1 drop/8 sec or less, and preferably 1 drop/100 sec or more, more preferably 1 drop/50 sec or more, still more preferably 1 drop/15 sec or more, from the viewpoint of ease of manufacturing, cost, storage stability of the dispersion, improvement of photoelectric conversion efficiency, and the like.

The time for allowing the quantum dot dispersion and the aliphatic amino acid solution to stand after mixing is preferably 0.1 hours or more, more preferably 1 hour or more, still more preferably 10 hours or more, and preferably 100 hours or less, more preferably 48 hours or less, still more preferably 24 hours or less, from the viewpoint of ease of manufacturing, cost, storage stability of the dispersion, improvement of photoelectric conversion efficiency, and the like.

As a method for obtaining a quantum dot solid having an aliphatic amino acid as a ligand after ligand exchange, a method of obtaining a quantum dot solid through a step of adding a washing solvent to a mixed dispersion of the quantum dot dispersion and the aliphatic amino acid solution, and filtering the mixture to remove the organic ligand coordinated to the surface of the quantum dot, the excessive aliphatic amino acid, and the solvent is preferable. The washing solvent is preferably an organic solvent in which quantum dots before and after ligand exchange are hardly dispersed and the organic ligand and the aliphatic amino acid are soluble. The washing solvent is more preferably an alcohol solvent and still more preferably methanol, from the viewpoint of ease of manufacturing, cost, storage stability of the dispersion, improvement of photoelectric conversion efficiency, and the like. The volume ratio of the washing solvent to the mixed dispersion of the quantum dot dispersion and the aliphatic amino acid solution is preferably 0.1 or more, more preferably 0.5 or more, still more preferably 1 or more, and preferably 10 or less, more preferably 5 or less, still more preferably 2 or less. The pore size of the filter at the time of filtration is preferably 0.1 µm or more, more preferably 0.2 µm or more, and preferably 1 µm or less, more preferably 0.5 µm or less, from the viewpoint of ease of manufacturing, cost, storage stability of the dispersion, improvement of photoelectric conversion efficiency, and the like. The material of the filter is preferably hydrophobic, more preferably polytetrafluoroethylene (PTFE).

It is preferable to obtain a dispersion containing one or more types selected from a perovskite compound and a precursor thereof and the quantum dot through a step (step 2) of mixing the quantum dot solid obtained in step 1 with a solution or a mixed liquid containing one or more types of substances selected from a perovskite compound and a precursor thereof.

The dispersion containing a perovskite compound and/or a precursor thereof and the quantum dot preferably contains a solvent, from the viewpoint of film-forming property, cost, storage stability, and expression of excellent performance (for example, photoelectric conversion property). Examples of the solvent include esters (methyl formate, ethyl formate, etc.), ketones (γ-butyrolactone, N-methyl-2-pyrrolidone, acetone, dimethyl ketone, diisobutyl ketone, etc.), ethers (diethyl ether, methyl tert-butyl ether, dimethoxymethane, 1,4-dioxane, tetrahydrofuran, etc.), alcohols (methanol, ethanol, 2-propanol, tert-butanol, methoxypropanol, diacetone alcohol, cyclohexanol, 2-fluoroethanol, 2,2,2-trifluoroethanol, 2,2,3,3-tetrafluoro-1-propanol, etc.), glycol ethers (cellosolves), amide-based solvents (N,N-dimethylformamide, acetamide, N,N-dimethylacetamide, etc.), nitrile-based solvents (acetonitrile, isobutyronitrile, propionitrile, methoxyacetonitrile etc.), carbonate-based solvents (ethylene carbonate, propylene carbonate, etc.), halogenated hydrocarbons (methylene chloride, dichloromethane, chloroform, etc.), hydrocarbons, dimethylsulfoxide, and the like.

The solvent of the dispersion is preferably a polar solvent, more preferably at least one solvent selected from ketones, amide-based solvents, and dimethylsulfoxide, still more preferably an amide-based solvent, even still more preferably N,N-dimethylformamide from the viewpoints of film forming properties, cost, storage stability, and expression of excellent performance (for example, photoelectric conversion characteristics).

In view of film-forming property, cost, storage stability, and expression of excellent performance (for example, photoelectric conversion characteristics), the metal concentration of the perovskite compound or its precursor in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.7 mol/L or less.

From the viewpoints of film-forming property, cost, storage stability, and expression of excellent performance (for example, photoelectric conversion characteristics), the solid content concentration of the quantum dots in the dispersion is preferably 10 mg/mL or more, more preferably 50 mg/mL or more, still more preferably 70 mg/mL or more, and preferably 400 mg/mL or less, more preferably 300 mg/mL or less, still more preferably 200 mg/mL or less, still more preferably 130 mg/mL or less.

The method for preparing the dispersion is not particularly limited, but the mixing temperature is preferably 0°C or higher, more preferably 10°C or higher, still more preferably 20°C or higher, and preferably 50°C or lower, more preferably 40°C or lower, still more preferably 30°C or lower, from the viewpoint of ease of manufacturing, cost, storage stability of the dispersion, improvement of photoelectric conversion efficiency, and the like. From the same viewpoint, the mixing time is preferably more than 0 hours, more preferably 0.1 hours or more, and preferably 72 hours or less, more preferably 24 hours or less, still more preferably 1 hour or less.

The dispersion is preferably filtered to remove coarse particles. The pore size of the filter at the time of filtration is preferably 0.1 µm or more, more preferably 0.2 µm or more, and preferably 1 µm or less, more preferably 0.5 µm or less, from the viewpoint of ease of manufacturing, cost, storage stability of the dispersion, improvement of photoelectric conversion efficiency, and the like. The material of the filter is preferably hydrophobic, more preferably polytetrafluoroethylene (PTFE).

The step (step 3) of obtaining a light absorption layer from the dispersion obtained in step 2 is preferably a wet process such as applying (coating) the dispersion obtained in step 2 onto a substrate (functional layer). Examples of the wet process include a gravure coating method, a bar coating method, a printing method, a spraying method, a spin coating method, a dipping method, and a die coating method. A spin coating method is preferable from the viewpoint of ease of manufacturing, cost, and expression of excellent performance (for example, photoelectric conversion property). The maximum rotation speed of the spin coater in the spin coating method is preferably 500 rpm or more, more preferably 1,000 rpm or more, still more preferably 2,000 rpm or more, and preferably 8,000 rpm or less, more preferably 7,000 rpm or less, still more preferably 6,000 rpm or less, from the viewpoint of exhibiting excellent performance (for example, photoelectric conversion property).

In addition, from the viewpoint of ease of manufacturing, cost, improvement of photoelectric conversion property, and the like, the crystal deposition rate of the perovskite compound may be improved by applying or dropping a poor solvent of a perovskite compound after applying the dispersion onto the substrate. The poor solvent is preferably toluene, chlorobenzene, dichloromethane, or a mixed solvent thereof.

As a drying method in the wet process, for example, a thermal drying method, an air stream drying method, a vacuum drying method and the like can be mentioned, from the viewpoints of ease of production, cost, and expression of excellent performance (for example, photoelectric conversion characteristics), and the thermal drying is preferable. The temperature of thermal drying is preferably 60°C or higher, more preferably 80°C or higher, and still more preferably 90°C or higher, from the viewpoint of exhibiting excellent performance (for example, photoelectric conversion property). The temperature of thermal drying is preferably 200°C or lower, more preferably 150°C or lower, still more preferably 120°C or lower, and still more preferably 110°C or lower from the same viewpoint and cost. The time for thermal drying is preferably 1 minute or more, more preferably 5 minutes or more, and still more preferably 8 minutes or more, from the viewpoint of exhibiting excellent performance (for example, photoelectric conversion property). The time for thermal drying is preferably 120 minutes or less, more preferably 60 minutes or less, still more preferably 20 minutes or less, and still more preferably 12 minutes or less from the same viewpoint and cost.

### <Photoelectric Conversion Element>

The photoelectric conversion element of the present invention has the light absorption layer. In the photoelectric conversion element of the present invention, the configuration other than the light absorption layer is not particularly limited, and a configuration of a known photoelectric conversion element can be applied. In addition, the photoelectric conversion element of the present invention can be manufactured by a known method, except for the light absorption layer.

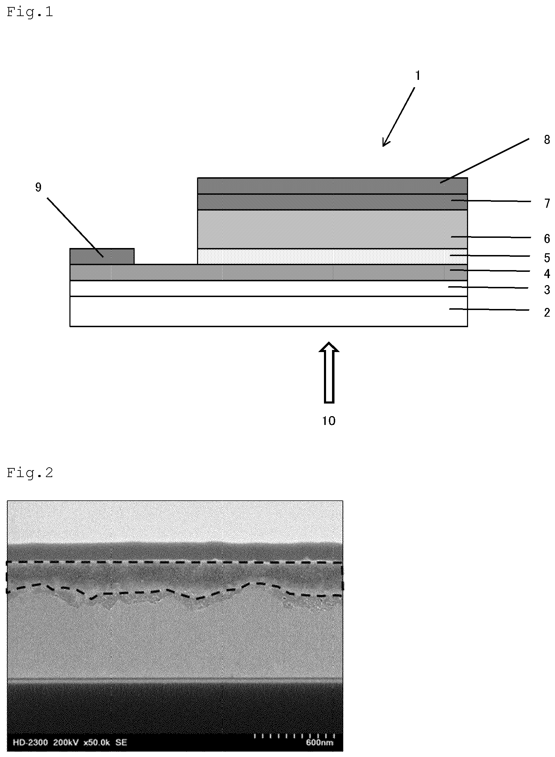

Hereinafter, the configuration and manufacturing method of the photoelectric conversion element of the present invention will be described with reference to Fig. 1, but Fig. 1 is merely an example, and the present invention is not limited to the embodiment shown in Fig. 1.

Fig. 1 is a schematic sectional view showing an example of a structure of a photoelectric conversion element of the present invention. A photoelectric conversion element 1 has a structure in which a transparent substrate 2, a transparent conductive layer 3, a blocking layer 4, a porous layer 5, a light absorption layer 6, and a hole transport layer 7 are sequentially laminated. A transparent electrode substrate on the incident side of light 10 is composed of the transparent substrate 2 and the transparent conductive layer 3, and the transparent conductive layer 3 is bonded to an electrode (negative electrode) 9 which is a terminal for electrically connecting to an external circuit. In addition, the hole transport layer 7 is bonded to an electrode (positive electrode) 8 which serves as a terminal for electrically connecting to an external circuit.

As the material of the transparent substrate 2, any material may be used as long as it has strength, durability and light permeability, and synthetic resin and glass can be used. Examples of the synthetic resin include thermoplastic resins such as polyethylene naphthalate (PEN) film, polyethylene terephthalate (PET), polyester, polycarbonate, polyolefin, polyimide, and fluorine resin. From the viewpoints of strength, durability, cost and the like, it is preferable to use a glass substrate.

As the material of the transparent conductive layer 3, for example, indium-added tin oxide (ITO), fluorine-added tin oxide (FTO), tin oxide (SnO₂), indium zinc oxide (IZO), zinc oxide (ZnO), a polymer material having high conductivity and the like can be mentioned. Examples of the polymer material include polyacetylene-based polymer materials, polypyrrole-based polymer materials, polythiophene-based polymer materials, and polyphenylenevinylene-based polymer materials. As the material of the transparent conductive layer 3, a carbon-based thin film having high conductivity can also be used. Examples of a method for forming the transparent conductive layer 3 include a sputtering method, a vapor deposition method, a method of coating a dispersion, and the like.

Examples of the material of the blocking layer 4 include titanium oxide, aluminum oxide, silicon oxide, niobium oxide, tungsten oxide, tin oxide, zinc oxide, and the like. Examples of a method for forming the blocking layer 4 include a method of directly sputtering the above material on the transparent conductive layer 3 and a spray pyrolysis method. In addition, there is a method wherein a solution in which the above material is dissolved in a solvent or a solution in which a metal hydroxide that is a precursor of a metal oxide is dissolved is coated on the transparent conductive layer 3, dried, and baked as necessary. Examples of the coating method include gravure coating, bar coating, printing, spraying, spin coating, dipping, die coating, and the like.

The porous layer 5 is a layer having a function of supporting the light absorption layer 6 on its surface. In order to increase the light absorption efficiency in the solar cell, it is preferable to increase the surface area of the portion receiving light. By providing the porous layer 5, it is possible to increase the surface area of such a light-receiving portion.

Examples of the material of the porous layer 5 include a metal oxide, a metal chalcogenide (for example, a sulfide and a selenide), a compound having a perovskite form crystal structure (excluding the light absorber described above), a silicon oxide (for example, silicon dioxide and zeolite), and carbon nanotubes (including carbon nanowires and carbon nanorods), and the like.

Examples of the metal oxide include oxides of titanium, tin, zinc, tungsten, zirconium, hafnium, strontium, indium, cerium, yttrium, lanthanum, vanadium, niobium, aluminum, tantalum, and the like, and examples of the metal chalcogenide include zinc sulfide, zinc selenide, cadmium sulfide, cadmium selenide, and the like.

Examples of the compound having a perovskite form crystal structure include strontium titanate, calcium titanate, barium titanate, lead titanate, barium zirconate, barium stannate, lead zirconate, strontium zirconate, strontium tantalate, potassium niobate, bismuth ferrate, barium strontium titanate, barium lanthanum titanate, calcium titanate, sodium titanate, bismuth titanate, and the like.

The material for forming the porous layer 5 is preferably used as fine particles, more preferably as a dispersion containing fine particles. Examples of a method for forming the porous layer 5 include a wet method, a dry method, and other methods (for example, methods described in Chemical Review, Vol. 110, page 6595 (2010)). In these methods, it is preferable to coating the surface of the blocking layer 4 with a dispersion (paste), followed by baking. By baking, the fine particles can be brought into close contact with each other. Examples of coating methods include gravure coating method, bar coating method, printing method, spraying method, spin coating method, dipping method, die coating method, and the like.

The light absorption layer 6 is the above-described light absorption layer of the present invention. A method of forming the light absorption layer 6 is not particularly limited, and, for example, there is preferably mentioned a method based on a so-called wet process in which a dispersion containing the perovskite compound or its precursor and the quantum dots containing the aliphatic amino acid is prepared and the prepared dispersion is coated on the surface of the porous layer 5, and is dried. The method for forming the light absorption layer 6 is preferably a manufacturing method including step 1, step 2, and step 3 described above, from the viewpoint of ease of manufacturing, cost, storage stability of the dispersion, improvement of photoelectric conversion efficiency, and the like.

As a material of the hole transport layer 7, there can be mentioned, for example, a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylene vinylene derivative, and the like. Examples of a method for forming the hole transport layer 7 include a coating method, a vacuum vapor deposition method and the like. Examples of the coating method include a gravure coating method, a bar coating method, a printing method, a spray method, a spin coating method, a dipping method, a die coating method, and the like.

As the material of the electrode (positive electrode) 8 and the electrode (negative electrode) 9, there can be mentioned, for example, metals such as aluminum, gold, silver and platinum; conductive metal oxides such as indium tin oxide (ITO), indium zinc oxide (IZO), and zinc oxide (ZnO); organic conductive materials such as conductive polymers; and carbon-based materials such as nanotubes. Examples of a method for forming the electrode (positive electrode) 8 and the electrode (negative electrode) 9 include a vacuum vapor deposition method, a sputtering method, a coating method, and the like.

### <Solar Cell>

The solar cell of the present invention has the photoelectric conversion element. In the solar cell of the present invention, the configuration other than the light absorption layer is not particularly limited, and a known solar cell configuration can be applied.

Hereinafter, the present invention and preferred embodiments of the present invention will be described.
<1> A light absorption layer, comprising:
   a perovskite compound; and
   a quantum dot containing an aliphatic amino acid.
<2> The light absorption layer according to <1>, having an intermediate band.
<3> The light absorption layer according to <1> or <2>, wherein the perovskite compound is preferably one or more types selected from a compound represented by the following general formula (1) and a compound represented by the following general formula (2), and more preferably a compound represented by the following general formula (1).

   RMX₃ (1)

   wherein R is a monovalent cation, M is a divalent metal cation, and X is a halogen anion, and

      R¹R²R³ₙ₋₁MₙX₃ₙ₊₁ (2)
   wherein R¹, R² and R³ are each independently a monovalent cation, M is a divalent metal cation, X is a halogen anion, and n is an integer of 1 to 10.
<4> The light absorption layer according to <3>, wherein R is one or more types selected from a cation of a first group element of the periodic table and an organic cation, the cation of a first group element of the periodic table is preferably one or more types selected from Li⁺, Na⁺, K⁺, and Cs⁺, the organic cation is preferably one or more types selected from an ammonium ion optionally having a substituent and a phosphonium ion optionally having a substituent, and the ammonium ion optionally having a substituent is preferably one or more types selected from an alkylammonium ion, a formamidinium ion, and an arylammonium ion, more preferably one or more types selected from an alkylammonium ion and a formamidinium ion, still more preferably one or more types selected from a monoalkylammonium ion and a formamidinium ion, still more preferably one or more types selected from a methylammonium ion, an ethylammonium ion, a butylammonium ion, and a formamidinium ion, and still more preferably a methylammonium ion.
<5> The light absorption layer according to <3>, wherein R¹, R², and R³ are one or more types selected from a cation of a first group element of the periodic table and an organic cation, the cation of a first group element of the periodic table is preferably one or more types selected from Li⁺, Na⁺, K⁺, and Cs⁺, the organic cation is preferably one or more types selected from an ammonium ion optionally having a substituent and a phosphonium ion optionally having a substituent, and the ammonium ion optionally having a substituent is preferably one or more types selected from an alkylammonium ion, a formamidinium ion, and an arylammonium ion, more preferably one or more types selected from an alkylammonium ion and a formamidinium ion, still more preferably a monoalkylammonium ion, still more preferably one or more types selected from a methylammonium ion, an ethylammonium ion, a butylammonium ion, a hexylammonium ion, an octylammonium ion, a decylammonium ion, a dodecylammonium ion, a tetradecylammonium ion, a hexadecylammonium ion, and an octadecylammonium ion.
<6> The light absorption layer according to <3> or <5>, wherein n is an integer of 1 or more and 4 or less.
<7> The light absorption layer according to <3> or <5>, wherein the M is preferably one or more kinds selected from Pb²⁺, Sn²⁺, Hg²⁺, Cd²⁺, Zn²⁺, Mn²⁺, Cu²⁺, Ni²⁺, Fe²⁺, Co²⁺, Pd²⁺, Ge²⁺, Y²⁺, and Eu²⁺, more preferably one or more kinds selected from Pb²⁺, Sn²⁺, or Ge²⁺, still more preferably one or more kinds selected from Pb²⁺ or Sn²⁺, even still more preferably Pb²⁺.
<8> The light absorption layer according to any one of <3> to <7>, wherein X is preferably one or more types selected from a fluorine anion, a chlorine anion, a bromine anion, and an iodine anion, more preferably a fluorine anion, a chlorine anion, or a bromine anion, still more preferably a chlorine anion or a bromine anion, and still more preferably a bromine anion.
<9> The light absorption layer according to any one of <1> to <8>, wherein the band gap energy of the perovskite compound is preferably 1.5 eV or more, more preferably 1.7 eV or more, still more preferably 2.0 eV or more, even still more preferably 2.1 eV or more, even still more preferably 2.2 eV or more, and preferably 4.0 eV or less, more preferably 3.6 eV or less, still more preferably 3.0 eV or less, still more preferably 2.4 eV or less.
<10> The light absorption layer according to any one of <3> to <9>, wherein the compound represented by the general formula (1) is preferably one or more types selected from CH₃NH₃PbBr₃ and CH(=NH)NH₃PbBr₃, and more preferably CH₃NH₃PbBr₃.
<11> The light absorption layer according to any one of <1> to <10>, wherein the quantum dot containing an aliphatic amino acid is a compound in which the aliphatic amino acid is coordinated to a surface of the quantum dot (compound in which the aliphatic amino acid is coordinated to a metal element constituting the quantum dot).
<12> The light absorption layer according to any one of <1> to <11>, wherein the quantum dot containing an aliphatic amino acid is a compound in which the aliphatic amino acid is coordinated to a surface of a metal chalcogenide.
<13> The light absorption layer according to any one of <1> to <11>, wherein the quantum dot containing an aliphatic amino acid preferably contains a Pb element, more preferably contains PbS or PbSe, and still more preferably contains PbS.
<14> The light absorption layer according to any one of <1> to <13>, wherein a metal constituting the perovskite compound and a metal constituting the quantum dot are preferably the same metal.
<15> The light absorption layer according to any one of <1> to <14>, wherein the aliphatic amino acid is a linear amino acid.
<16> The light absorption layer according to any one of <1> to <15>, wherein the aliphatic amino acid preferably has 10 or less carbon atoms, more preferably 8 or less carbon atoms, still more preferably 7 or less carbon atoms, and preferably 2 or more carbon atoms, more preferably 3 or more carbon atoms.
<17> The light absorption layer according to any one of <1> to <16>, wherein an amino group of the aliphatic amino acid is at a terminal of a carbon chain.
<18> The light absorption layer according to any one of <1> to <17>, wherein the band gap energy of the quantum dot is 0.2 eV or more and equal to or less than the band gap energy of the perovskite compound.
<19> The light absorption layer according to any one of <1> to <18>, wherein the band gap energy of the quantum dot is preferably 0.7 eV or more, more preferably 0.8 eV or more, still more preferably 0.9 eV or more, even still more preferably 1.0 eV or more, and preferably 1.6 eV or less, more preferably 1.5 eV or less, still more preferably 1.4 eV or less.
<20> The light absorption layer according to any one of <1> to <19>, wherein a difference between a band gap energy of the perovskite compound and a band gap energy of the quantum dot is preferably 0.4 eV or more, more preferably 0.6 eV or more, still more preferably 0.8 eV or more, and preferably 2.0 eV or less, more preferably 1.5 eV or less, still more preferably 1.3 eV or less.
<21> The light absorption layer according to any one of <1> to <18>, wherein preferably, the band gap energy of the quantum dot is 0.7 eV or more and 1.6 eV or less, and the difference between the band gap energy of the perovskite compound and the band gap energy of the quantum dot is 0.4 eV or more and 2.0 eV or less,
   more preferably, the band gap energy of the quantum dot is 0.8 eV or more and 1.5 eV or less, and the difference between the band gap energy of the perovskite compound and the band gap energy of the quantum dot is 0.6 eV or more and 1.5 eV or less,
   still more preferably, the band gap energy of the quantum dot is 0.9 eV or more and 1.4 eV or less, and the difference between the band gap energy of the perovskite compound and the band gap energy of the quantum dot is 0.8 eV or more and 1.3 eV or less, and
   still more preferably, the band gap energy of the quantum dot is 1.0 eV or more and 1.4 eV or less, and the difference between the band gap energy of the perovskite compound and the band gap energy of the quantum dot is 0.8 eV or more and 1.3 eV or less.
<22> The light absorption layer according to any one of <1> to <21>, wherein the quantum dot contains at least one type of organic ligand selected from the group consisting of a carboxy group-containing compound other than the aliphatic amino acid, an amino group-containing compound other than the aliphatic amino acid, a thiol group-containing compound, and a phosphino group-containing compound.
<23> The light absorption layer according to <22>, wherein the organic ligand is preferably the carboxy group-containing compound or the amino group-containing compound, more preferably the carboxy group-containing compound, still more preferably a carboxylic acid, still more preferably a fatty acid, still more preferably a fatty acid having 8 or more and 30 or less carbon atoms, still more preferably a fatty acid having 12 or more and 18 or less carbon atoms, still more preferably an unsaturated fatty acid having 12 or more and 18 or less carbon atoms, and still more preferably oleic acid.
<24> The light absorption layer according to any one of <1> to <23>, wherein a combination of the perovskite compound and the quantum dot containing an aliphatic amino acid is a combination of CH₃NH₃PbBr₃ and PbS in which the aliphatic amino acid is coordinated.
<25> A light absorption layer containing: a perovskite compound; and a quantum dot, wherein
   the perovskite compound is CH₃NH₃PbBr₃, and
   the quantum dot is a compound in which a linear amino acid having 3 or more and 10 or less carbon atoms is coordinated to a surface of PbS.
<26> The light absorption layer according to any one of <1> to <25>, wherein a content of the quantum dot in the light absorption layer is preferably 7.5% by mass or more, more preferably 10% by mass or more, and still more preferably 12% by mass or more, and preferably 40% by mass or less, more preferably 30% by mass or less, still more preferably 25% by mass or less, and still more preferably 20% by mass or less.
<27> The light absorption layer according to any one of <1> to <26>, wherein a porosity of the light absorption layer is preferably 10% or less, more preferably 8% or less, still more preferably 5% or less, and still more preferably 0%.
<28> The light absorption layer according to any one of <1> to <25>, wherein the content of the quantum dot in the light absorption layer is preferably 7.5% by mass or more and 40% by mass or less, and the porosity of the light absorption layer is 10% or less,
   more preferably, the content of the quantum dot in the light absorption layer is 10% by mass or more and 30% by mass or less, and the porosity of the light absorption layer is 8% or less,
   still more preferably, the content of the quantum dot in the light absorption layer is 12% by mass or more and 25% by mass or less, and the porosity of the light absorption layer is 5% or less, and
   still more preferably, the content of the quantum dot in the light absorption layer is 12% by mass or more and 20% by mass or less, and the porosity of the light absorption layer is 0%.
<29> The light absorption layer according to any one of <1> to <28>, wherein a coverage of the light absorption layer with respect to a functional layer (for example, a porous layer) is preferably 80% or more, more preferably 90% or more, still more preferably 95% or more, and still more preferably 100%.
<30> A dispersion containing: a perovskite compound or a precursor thereof; and a quantum dot containing an aliphatic amino acid.
<31> The dispersion according to <30>, wherein the dispersion contains a solvent.
<32> The dispersion according to <30> or <31>, wherein a solid content concentration of the quantum dot in the dispersion is 10 mg/mL or more and 400 mg/mL or less.
<33> A light absorption layer obtained from the dispersion according to any one of <30> to <32>.
<34> A method for manufacturing a light absorption layer in which a quantum dot containing an aliphatic amino acid is dispersed in a matrix of a perovskite compound, the method comprising following steps 1, 2, and 3.
   (step 1) a step of exchanging an organic ligand of the quantum dot containing the organic ligand with an aliphatic amino acid to obtain a quantum dot solid containing an aliphatic amino acid as a ligand;
   (step 2) a step of mixing the quantum dot solid obtained in step 1 with a solution or a mixed liquid containing one or more types of substances selected from a perovskite compound and a precursor thereof to obtain a dispersion; and
   (step 3) a step of obtaining a light absorption layer from the dispersion obtained in step 2.
<35> The method for manufacturing a light absorption layer according to <34>, wherein the aliphatic amino acid is preferably an aliphatic amino acid having 2 to 10 carbon atoms, more preferably an aliphatic amino acid having 3 to 8 carbon atoms, and still more preferably an aliphatic amino acid having 3 to 7 carbon atoms.
<36> The method for manufacturing a light absorption layer according to <34> or <35>, wherein in step 1, the ligand exchange is preferably performed in a dispersion, more preferably by mixing a dispersion of a quantum dot containing an organic ligand with a solution containing an aliphatic amino acid.
<37> The method for manufacturing a light absorption layer according to <36>, wherein a mixing amount of the aliphatic amino acid used for ligand exchange is preferably 0.1 or more, more preferably 1 or more, still more preferably 1.5 or more, and preferably 10 or less, more preferably 8 or less, still more preferably 5 or less, still more preferably 3 or less as a molar ratio of the aliphatic amino acid to the organic ligand on a surface of the quantum dot.
<38> The method for manufacturing a light absorption layer according to <36> or <37>, wherein the solvent used for ligand exchange is a mixed solvent of a solvent for dispersing the quantum dot and a solvent for dissolving the aliphatic amino acid, the solvent for dispersing the quantum dot is preferably one or more types of non-(low) polar organic solvents selected from toluene, hexane, and octane, more preferably toluene, and the solvent for dissolving the aliphatic amino acid is preferably one or more types of aprotic polar organic solvents selected from N,N-dimethylformamide, dimethyl sulfoxide, and γ-butyrolactone, more preferably N,N-dimethylformamide.
<39> The method for manufacturing a light absorption layer according to any one of <36> to <38>, wherein a solid content concentration of the quantum dot to be mixed in the quantum dot dispersion at the time of ligand exchange is preferably 10 mg/mL or more, more preferably 50 mg/mL or more, still more preferably 80 mg/mL or more, and preferably 1,000 mg/mL or less, more preferably 500 mg/mL or less, still more preferably 200 mg/mL or less, still more preferably 120 mg/mL or less.
<40> The method for manufacturing a light absorption layer according to any one of <36> to <39>, wherein a concentration of the aliphatic amino acid to be mixed in the aliphatic amino acid solution at the time of ligand exchange is preferably 0.01 mol/L or more, more preferably 0.1 mol/L or more, still more preferably 0.2 mol/L or more, and preferably 1 mol/L or less, more preferably 0.5 mol/L or less, still more preferably 0.3 mol/L or less.
<41> The method for manufacturing a light absorption layer according to any one of <36> to <40>, wherein a method for mixing the quantum dot dispersion and the aliphatic amino acid solution at the time of ligand exchange is preferably a continuous method or a dropping method (semi-continuous method), and more preferably a dropping method.
<42> The method for manufacturing a light absorption layer according to <41>, wherein the continuous method is a method of mixing the aliphatic amino acid solution in the quantum dot dispersion, and a mixing rate is preferably 25 µL/sec or less, more preferably 5 µL/sec or less, still more preferably 3 µL/sec or less, and preferably 0.2 µL/sec or more, more preferably 0.4 µL/sec or more, still more preferably 1.5 µL/sec or more.
<43> The method for manufacturing a light absorption layer according to <41>, wherein the dropping method is a method of dropping the aliphatic amino acid solution into the quantum dot dispersion, and a dropping rate is preferably 1 drop/1 sec or less, more preferably 1 drop/5 sec or less, still more preferably 1 drop/8 sec or less, and preferably 1 drop/100 sec or more, more preferably 1 drop/50 sec or more, still more preferably 1 drop/15 sec or more.
<44> The method for manufacturing a light absorption layer according to any one of <36> to <43>, wherein a time for allowing the quantum dot dispersion and the aliphatic amino acid solution to stand after mixing is preferably 0.1 hours or more, more preferably 1 hour or more, still more preferably 10 hours or more, and preferably 100 hours or less, more preferably 48 hours or less, still more preferably 24 hours or less.
<45> The method for manufacturing a light absorption layer according to any one of <36> to <44>, wherein a method for obtaining a quantum dot solid having an aliphatic amino acid as a ligand after ligand exchange is a step of adding a washing solvent to a mixed dispersion of the quantum dot dispersion and the aliphatic amino acid solution, followed by filtering to remove the organic ligand coordinated to a surface of the quantum dot, an excessive portion of the aliphatic amino acid, and the solvent, and the washing solvent is preferably an organic solvent in which quantum dots before and after ligand exchange are hardly dispersed and the organic ligand and the aliphatic amino acid are soluble, more preferably an alcohol solvent, and still more preferably methanol.
<46> The method for manufacturing a light absorption layer according to <45>, wherein an amount of the washing solvent is preferably 0.1 or more, more preferably 0.5 or more, still more preferably 1 or more, and preferably 10 or less, more preferably 5 or less, still more preferably 2 or less as a volume ratio of the washing solvent to an amount of a mixed dispersion of the quantum dot dispersion and the aliphatic amino acid solution.
<47> The method for manufacturing a light absorption layer according to <45> or <46>, wherein a pore size of a filter at the time of filtration is preferably 0.1 µm or more, more preferably 0.2 µm or more, and preferably 1 µm or less, more preferably 0.5 µm or less, and a material of the filter is preferably hydrophobic, more preferably polytetrafluoroethylene (PTFE).
<48> The method for manufacturing a light absorption layer according to any one of <34> to <47>, wherein the dispersion contains a solvent.
<49> The method for manufacturing a light absorption layer according to <48>, wherein the solvent is preferably a polar solvent, more preferably at least one type of solvent selected from ketones, amide-based solvents, and dimethyl sulfoxide, still more preferably an amide-based solvent, and still more preferably N,N-dimethylformamide.
<50> The method for manufacturing a light absorption layer according to any one of <34> to <49>, wherein a metal concentration of the perovskite compound and/or the precursor thereof in the dispersion is preferably 0.1 mol/L or more, more preferably 0.2 mol/L or more, still more preferably 0.3 mol/L or more, and preferably 1.5 mol/L or less, more preferably 1.0 mol/L or less, still more preferably 0.7 mol/L or less.
<51> The method for manufacturing a light absorption layer according to any one of <34> to <50>, wherein a solid content concentration of the quantum dot in the dispersion is preferably 10 mg/mL or more, more preferably 50 mg/mL or more, still more preferably 70 mg/mL or more, and preferably 400 mg/mL or less, more preferably 300 mg/mL or less, still more preferably 200 mg/mL or less, still more preferably 130 mg/mL or less.
<52> The method for manufacturing a light absorption layer according to any one of <34> to <51>, wherein a mixing temperature at the time of preparing the dispersion is preferably 0°C or higher, more preferably 10°C or higher, still more preferably 20°C or higher, and preferably 50°C or lower, more preferably 40°C or lower, still more preferably 30°C or lower.
<53> The method for manufacturing a light absorption layer according to any one of <34> to <52>, wherein a mixing time at the time of preparing the dispersion is preferably more than 0 hour, more preferably 0.1 hours or more, and preferably 72 hours or less, more preferably 24 hours or less, still more preferably 1 hour or less.
<54> The method for manufacturing a light absorption layer according to any one of <34> to <53>, wherein the dispersion is obtained by filtering to remove coarse particles, the pore size of the filter at the time of filtration is preferably 0.1 µm or more, more preferably 0.2 µm or more, and preferably 1 µm or less, more preferably 0.5 µm or less, and a material of the filter is preferably hydrophobic, and more preferably polytetrafluoroethylene (PTFE).
<55> The method for manufacturing a light absorption layer according to any one of <34> to <54>, wherein step 3 is preferably a wet process, more preferably a spin coating method, and a maximum rotation speed of a spin coater in the spin coating method is preferably 500 rpm or more, more preferably 1,000 rpm or more, still more preferably 2,000 rpm or more, and preferably 8,000 rpm or less, more preferably 7,000 rpm or less, still more preferably 6,000 rpm or less.
<56> The method for manufacturing a light absorption layer according to any one of <34> to <55>, wherein in step 3, after the dispersion is applied onto a substrate, a poor solvent of the perovskite compound is applied or dropped onto the substrate, thereby improving a crystal deposition rate of the perovskite compound.
<57> The method for manufacturing a light absorption layer according to <56>, wherein the poor solvent is toluene, chlorobenzene, dichloromethane, or a mixed solvent thereof.
<58> The method for manufacturing a light absorption layer according to any one of <55> to <57>, wherein a drying method in the wet process is preferably thermal drying, a temperature of the thermal drying is preferably 60°C or higher, more preferably 80°C or higher, still more preferably 90°C or higher, and preferably 200°C or lower, more preferably 150°C or lower, still more preferably 120°C or lower, still more preferably 110°C or lower, and a time of the thermal drying is preferably 1 minute or more, more preferably 5 minutes or more, still more preferably 8 minutes or more, and preferably 120 minutes or less, more preferably 60 minutes or less, still more preferably 20 minutes or less, still more preferably 12 minutes or less.
<59> A photoelectric conversion element including the light absorption layer according to any one of <1> to <29>, and <33>.
<60> A solar cell having the photoelectric conversion element according to <59>.

### EXAMPLES

Hereinafter, the present invention will be specifically described based on Examples. The evaluation and measurement methods are as follows. Unless otherwise specified, the measurement was performed in an environment of 25°C and normal pressure. Note that "normal pressure" refers to 101.3 kPa.

### <I-V Curve>

Using an I-V characteristic measuring device (PECK 2400-N, manufactured by Peccell Technologies, Inc.) with a xenon-lamp white light as a light source (PEC-L01, manufactured by Peccell Technologies, Inc.) at a light intensity (100 mW/cm²) equivalent to sunlight (AM 1.5) under a mask of light irradiation area 0.0363 cm² (2 mm square), an I-V curve of the cell was measured under the conditions of a scanning speed of 0.1 V/sec (0.01 V step), a waiting time of 50 msec after voltage setting, a measurement integration time of 50 msec, a starting voltage of -0.1 V, and an ending voltage of 1.1 V. The light intensity was corrected with a silicon reference (BS-520, 0.5714 mA). The short-circuit current density (mA/cm²), open circuit voltage (V), and fill factor (FF) were determined from the I-V curve.

### <Absorption Spectrum>

Using a UV-Vis spectrophotometer (SolidSpec-3700, manufactured by Shimadzu Corporation) under the conditions of a scanning speed of medium speed, a sample pitch of 1 nm, a slit width of 20, and an integrating sphere detector unit, the absorption spectrum of the light absorption layer was measured in the range of 300 to 1600 nm on a sample before applying the hole transport material. Background measurement was carried out with a fluorine-doped tin oxide (FTO) substrate (manufactured by Asahi Glass Fabritec Co., Ltd., 25 × 25 × 1.8 mm).

The absorption spectrum of the PbS quantum dot dispersion was similarly measured in a dispersion having a concentration of 0.1 to 1 mg/mL of PbS quantum dot solid using a 1 cm square quartz cell. In the case of a PbS quantum dot in which oleic acid was coordinated, hexane was used as a dispersion solvent, and in the case of a PbS quantum dot in which amino acid was coordinated, N,N-dimethylformamide (DMF) was used as a dispersion solvent.

Note that the absorption spectrum of the horizontal axis representing the wavelength λ and the vertical axis representing the absorbance A was converted into the spectrum of the horizontal axis representing the energy hν and the vertical axis representing (αhν)^{1/2} (α; absorption coefficient), and a straight line was fitted to the rising part of absorption and the intersection of the straight line and the baseline was taken as the band gap energy.

### <Composition of PbS quantum dot solid>

The Pb concentration in the PbS quantum dot solid was quantified by high frequency inductively coupled plasma-atomic emission spectroscopy (ICP) after completely dissolving the PbS quantum dot solid in a mixed solution of nitric acid and hydrogen peroxide.

The oleic acid concentration in the PbS quantum dot solid was quantified by a proton (¹H) nuclear magnetic resonance (NMR) method using a deuterated toluene (99 atom% D, containing 0.03 vol% of TMS, manufactured by Sigma-Aldrich Japan K.K.) solvent as an internal standard substance. The measurement was carried out using an NMR apparatus (VNMRS 400 manufactured by Agilent Company) under the conditions of a resonance frequency of 400 HHz, a delay time of 60 seconds, and a 32 times-integration, and the concentration of oleate anion in the PbS quantum dot solid was determined from the ratio of the integral value of the vinyl proton (5.5 ppm vs. TMS) of the oleate anion to the integral value of dibromomethane (3.9 ppm vs. TMS).

### <Synthesis of PbS quantum dot coordinated with oleic acid>

Lead oxide (0.45 g, manufactured by FUJIFILM Wako Pure Chemical Corporation), 10 g of octadecene (manufactured by Sigma-Aldrich Japan K.K.), and 1.34 g of oleic acid (manufactured by Sigma-Aldrich Japan K.K.) were charged into a 50 mL three-necked flask, and the resulting mixture was stirred at 80°C for 2 hours to prepare a Pb source solution. The inside of the reaction system was evacuated by a vacuum pump, nitrogen gas was introduced to return the pressure to atmospheric pressure, and then the mixture was further stirred at 110°C for 30 minutes. On the other hand, 210 µL of 1,1,1,3,3,3-hexamethyldisilathiane (manufactured by Tokyo Chemical Industry Co., Ltd.) was dissolved in 4 mL of octadecene to prepare an S source solution. Under stirring and nitrogen gas atmosphere at 110°C, the S source solution was injected into the Pb source solution at once using a syringe to produce PbS quantum dots in which oleic acid was coordinated. A large excess of acetone was added to stop the reaction, then the supernatant was removed by centrifugation (CR21 GIII, R15A rotor, manufactured by Hitachi Koki Co., Ltd., 2,500 rpm, 2 minutes), and the precipitate was dried under reduced pressure to obtain a PbS quantum dot solid in which oleic acid was coordinated.

Regarding concentration of each component in the PbS quantum dot solid in which oleic acid was coordinated, the Pb concentration was 66% by mass, the oleic acid concentration was 22% by mass, and the ratio of oleic acid/Pb (molar ratio) was 0.25. The X-ray diffraction result showed that the crystallite diameter was 2.7 nm, and the absorption spectrum showed that the absorption edge wavelength was 1,070 nm and the absorption peak wavelength was 970 nm (the peak absorbance of a hexane dispersion having a solid content concentration of 1 mg/mL was 0.501).

### <Coverage of Light Absorption Layer>

The coverage of the light absorption layer was calculated from the area ratio (area rate) of the light absorption layer to the whole area by measuring the SEM photograph (enlargement magnification: 20000 times) of the surface of the light absorption layer on a sample before applying a hole transport material, using a field emission high-resolution scanning electron microscope (FE-SEM "S-4800", manufactured by Hitachi, Ltd.), and by specifying the light absorption layer with a pen tool from the SEM photograph with use of an image analysis software (Winroof).

### <Measurement of porosity>

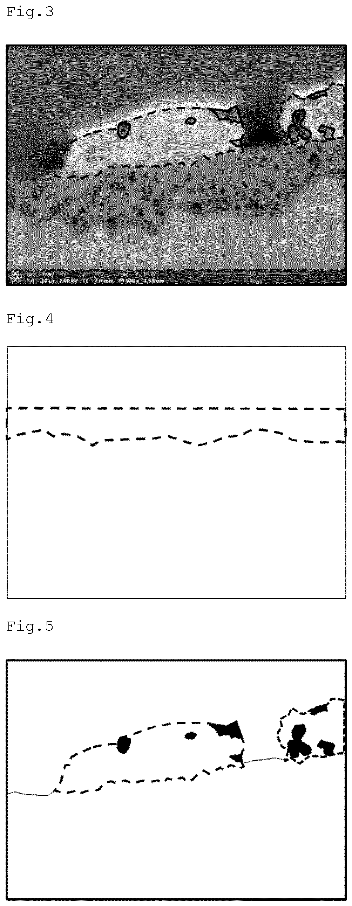

First, a cross section of the light absorption layer was observed using cryoFIB-SEM (Scios DualBeam, manufactured by FEI Company) (Figs. 2 and 3). In order to protect the surface of the sample, the surface was coated with platinum palladium twice for 120 seconds, and a carbon protective film was formed on the observation site in the FIB-SEM apparatus. The sample was subjected to FIB cross section processing at 30 kV and 0.3 nA, Z contrast was detected by reflected electrons. Observation was performed at an acceleration voltage of 2 kV, WD of 1 mm, and a magnification of 100,000 times.

Next, binarization processing was performed at a threshold of 120 using image analysis software (WinROOF 2013, manufactured by MITANI Corporation). The proportion of the portion where voids were formed was calculated (Fig. 4 corresponds to Fig. 2, and Fig. 5 corresponds to Fig. 3). The porosity was measured for the entire region of the cross section of the light absorption layer subjected to cross-sectional SEM observation. The porosity here is a proportion of voids (portions filled with black in Figs. 4 and 5) in the light absorption layer (portions surrounded by broken line in Figs. 4 and 5), and is an average value in all the solid in the visual field.

### Example 1

### <Synthesis of PbS quantum dot coordinated with 3-aminopropanoic acid>

A PbS quantum dot solid in which oleic acid was coordinated (0.20 g) was dispersed in 2 mL of toluene (anhydrous, manufactured by FUJIFILM Wako Pure Chemical Corporation) to obtain a black transparent dispersion. On the other hand, 3-aminopropanoic acid hydroiodide (0.072 g, manufactured by Tokyo Chemical Industry Co., Ltd.) was dissolved in 0.5 mL of DMF (anhydrous, manufactured by FUJIFILM Wako Pure Chemical Corporation), and 1 mL of toluene (anhydrous, manufactured by FUJIFILM Wako Pure Chemical Corporation) to obtain an amino acid salt solution (3-aminopropanoic acid hydroiodide/oleic acid (molar ratio) = 2). The amino acid salt solution was added dropwise to the PbS quantum dot dispersion at a dropping rate of 1 drop/10 sec (dropping time: 11 minutes) at room temperature (25°C) under a nitrogen atmosphere (in a glove box) without stirring, and then the mixture was allowed to stand for 18 hours. Further, 5 mL of methanol was added, and after mixing, the mixture was filtered through a filter (pore size: 0.2 µm, material: PTFE) and dried to obtain a PbS quantum dot solid in which 3-aminopropanoic acid was coordinated.

The following steps (1) to (7) were carried out sequentially to prepare a cell.

### (1) Etching and Cleaning of FTO Substrate

A part of a glass substrate with 25 mm square fluorine doped tin oxide (FTO) (manufactured by Asahi Glass Fabritec Corporation, 25 × 25 × 1.8 mm, hereinafter referred to as FTO substrate) was etched with Zn powder and a 2 mol/L hydrochloric acid aqueous solution. Ultrasonic cleaning was carried out for 10 minutes sequentially with 1 mass% neutral detergent, acetone, 2-propanol (IPA), and ion exchanged water.

### (2) Ozone Cleaning

Ozone cleaning of the FTO substrate was performed immediately before the compact TiO₂ layer forming step. With the FTO side facing up, the substrate was placed in an ozone generator (ozone cleaner PC-450 UV, manufactured by Meiwafosis Co., Ltd.) and irradiated with UV for 30 minutes.

### (3) Formation of Compact TiO₂ Layer (Blocking Layer)

Bis(2,4-pentanedionato)bis(2-propanolato) titanium (IV) (4.04 g, 75% IPA solution, manufactured by Tokyo Chemical Industry Co., Ltd.) was dissolved in 123.24 g of ethanol (anhydrous, manufactured by Wako Pure Chemical Industries) to prepare a spray solution. The spray solution was sprayed at a pressure of 0.3 MPa to an FTO substrate on a hot plate (450°C) from a height of about 30 cm. Spraying was repeated twice on the substrates of 20 cm × 8 rows to a spraying amount of about 7 g, and then the sprayed substrate was dried at 450°C for 3 minutes. This operation was repeated twice more to spray a total of about 21 g of the spray solution. Thereafter, the FTO substrate was immersed in an aqueous solution (50 mM) of titanium chloride (manufactured by Wako Pure Chemical Industries, Ltd.) and heated at 70°C for 30 minutes. After washing with water and drying, the FTO substrate was calcined at 500°C for 20 minutes (temperature rising: 15 minutes) to form a compact TiO₂ (cTiO₂) layer.

### (4) Formation of Mesoporous TiO₂ Layer (Porous Layer)

Ethanol (1.41 g, anhydrous, manufactured by Wako Pure Chemical Industries, Ltd.) was added to 0.404 g of an anatase form TiO₂ paste (PST-18NR, manufactured by JGC Catalysts and Chemicals Ltd.) and the mixture was subjected to ultrasonic dispersion for 1 hour to obtain a TiO₂ coating liquid. In a dry room, the TiO₂ coating liquid was spin-coated (5000 rpm × 30 sec) on the cTiO₂ layer using a spin coater (MS-100, manufactured by Mikasa Co., Ltd.). After drying for 30 minutes on a hot plate at 125°C, the cTiO₂ layer was calcined at 500°C for 30 minutes (time for temperature rising: 60 minutes) to form a mesoporous TiO₂ (mTiO₂) layer.

### (5) Formation of light absorption layer

The light absorption layer and the hole transport layer were formed in a glove box at 25°C. Lead bromide (0.183 g, PbBr₂, for perovskite precursor, manufactured by Tokyo Chemical Industry Co., Ltd.), 0.056 g of methylamine hydrobromide (CH₃NH₃Br, manufactured by Tokyo Chemical Industry Co., Ltd.), 0.9 mL of DMF (anhydrous, manufactured by FUJIFILM Wako Pure Chemical Corporation), and 0.1 mL of DMSO (anhydrous, manufactured by FUJIFILM Wako Pure Chemical Corporation) were mixed and stirred at room temperature to prepare a DMF/DMSO solution (colorless and transparent) of a 0.5 mol/L perovskite (CH₃NH₃PbBr₃) raw material. Further, 0.18 g of the PbS quantum dot solid in which 3-aminopropanoic acid was coordinated was added to the DMF/DMSO solution. The mixture was stirred for 15 minutes for dispersion, and then filtered through a PTFE filter having a pore size of 0.45 pm, thereby obtaining a mixed dispersion (coating liquid) of the PbS quantum dot and the perovskite raw material.

The mTiO₂ layer was spin-coated with the coating liquid by a spin coater (manufactured by Mikasa Co., Ltd., MS-100) (5,000 rpm × 30 sec). After 5 seconds from the start of spinning, 1 mL of chlorobenzene (manufactured by Sigma-Aldrich Co. LLC.) as a poor solvent was dropped at once to the center of the spin. Immediately after spin coating, the coated product was dried on a 100°C hot plate for 10 minutes to form a light absorption layer. The light absorption layer contains a perovskite compound (CH₃NH₃PbBr₃), a PbS quantum dot, and a ligand. Formation of the perovskite compound was confirmed by X-ray diffraction pattern, absorption spectrum, and electron microscope observation, and presence of the quantum dot was also confirmed from fluorescence spectrum and electron microscope observation.

### (6) Formation of Hole Transport Layer

Bis(trifluoromethanesulfonyl)imide lithium (LiTFSI, 9.1 mg, manufactured by Wako Pure Chemical Industries, Ltd.), 8.7 mg of [tris(2-(1H-pyrazol-1-yl)-4-tert-butylpyridine) cobalt(III) tris(bis(trifluoromethylsulfonyl)imide)] (Co(4-tButylpyridyl-2-1H-pyrazole) 3.3 TFSI, manufactured by Wako Pure Chemical Industries, Ltd.), 72.3 mg of 2,2',7,7'-tetrakis[N,N-di-p-methoxyphenylamino]-9,9'-spirobifluorene (Spiro-OMeTAD, manufactured by Wako Pure Chemical Industries, Ltd.), 1 mL of chlorobenzene (manufactured by Nacalai Tesque), and 28.8 µL of tributylphosphine (TBP, manufactured by Sigma-Aldrich) were mixed and stirred at room temperature to prepare a hole transport material (HTM) solution (black-purple transparent). Immediately before use, the HTM solution was filtered through a PTFE filter with a pore size of 0.45 µm. The HTM solution was spin-coated (4000 rpm × 30 sec) on the light absorption layer using a spin coater (MS-100, manufactured by Mikasa Co., Ltd.). Immediately after spin coating, the spin-coated product was dried on a 70°C hot plate for 30 minutes. After drying, the contact portion with FTO and the entire back surface of the substrate were wiped off with a cotton swab impregnated with γ-butyrolactone (manufactured by FUJIFILM Wako Pure Chemical Corporation), and the resulting product was further dried on a hot plate at 70°C for several minutes to form a hole transport layer.

### (7) Deposition of Gold Electrode

Gold was deposited to a thickness of 100 nm on the hole transport layer (vacuum deposition rate: 1 to 2 Å/sec) under vacuum (4 to 5 × 10⁻³ Pa) using a vacuum vapor deposition apparatus (VTR-060M/ERH, manufactured by ULVAC KIKO Inc.) to form a gold electrode.

### Example 2

A light absorption layer was formed and then a cell was produced in the same way as in Example 1 except that in item (5) Formation of light absorption layer in Example 1, instead of 3-aminopropanoic acid hydroiodide, 4-aminobutanoic acid hydroiodide (0.077 g, manufactured by Tokyo Chemical Industry Co., Ltd.) were used.

### Example 3

A light absorption layer was formed and then a cell was produced in the same way as in Example 1 except that in item (5) Formation of light absorption layer in Example 1, instead of 3-aminopropanoic acid hydroiodide, 5-aminoheptanoic acid hydroiodide (0.082 g, manufactured by Tokyo Chemical Industry Co., Ltd.) were used.

### Comparative Example 1

A light absorption layer was formed and then a cell was produced in the same way as in Example 1 except that in item (5) Formation of light absorption layer in Example 1, instead of 3-aminopropanoic acid hydroiodide, methylammonium hydroiodide (0.053 g, manufactured by Tokyo Chemical Industry Co., Ltd.) were used.

**[Table 1]**

| | | Example 1 | Example 2 | Example 3 | Comparative Example 1 |
|---|---|---|---|---|---|
| Perovskite (P) | Compound | CH₃NH₃PbBr₃ | CH₃NH₃PbBr₃ | CH₃NH₃PbBr₃ | CH₃NH₃PbBr₃ |
| | Band gap energy (eV) | 2.3 | 2.3 | 2.3 | 2.3 |
| Quantum dot (QD) | Compound | PbS | PbS | PbS | PbS |
| | Ligand | 3-aminopropanoic acid | 4-aminobutanoic acid | 5-aminoheptanoic acid | Iodine |
| | Band gap energy (eV) | 1.2 | 1.2 | 1.2 | 1.2 |
| | Blending amount (% by in terms of PbS mass) | 14 | 14 | 14 | 12 |
| Light absorption layer | Coverage (%) | 100 | 100 | 100 | 75 |
| | Porosity (average value) (%) | 0 | 0 | 0 | 12 |
| Cell property | Open circuit (V) voltage | 0.50 | 0.47 | 0.45 | 0.36 |
| | Fill factor | 0.54 | 0.51 | 0.57 | 0.44 |

### INDUSTRIAL APPLICABILITY

The light absorption layer and the photoelectric conversion element of the present invention can be suitably used as a constituent member of a next generation solar cell.

### DESCRIPTION OF REFERENCE SIGNS

- 1: Photoelectric conversion element
- 2: Transparent substrate
- 3: Transparent conductive layer
- 4: Blocking layer
- 5: Porous layer
- 6: Light absorption layer
- 7: Hole transport layer
- 8: Electrode (positive electrode)
- 9: Electrode (negative electrode)
- 10: Light

## Claims

1. A light absorption layer, comprising:
a perovskite compound; and
a quantum dot containing an aliphatic amino acid.

2. The light absorption layer according to claim 1, having an intermediate band.

3. The light absorption layer according to claim 1 or 2, wherein a content of the quantum dot is 7.5% by mass or more.

4. The light absorption layer according to any one of claims 1 to 3, wherein a band gap energy of the perovskite compound is 1.5 eV or more and 4.0 eV or less.

5. The light absorption layer according to any one of claims 1 to 4, wherein a band gap energy of the quantum dot is 0.2 eV or more and equal to or less than the band gap energy of the perovskite compound.

6. The light absorption layer according to any one of claims 1 to 5, wherein a porosity of the light absorption layer is 10% or less.

7. The light absorption layer according to any one of claims 1 to 6, wherein the perovskite compound is one or more kinds selected from a compound represented by the following general formula (1) and a compound represented by the following general formula (2):
RMX₃ (1)
wherein R is a monovalent cation, M is a divalent metal cation, and X is a halogen anion, and
R¹R²R³ₙ₋₁MₙX₃ₙ₊₁ (2)
wherein R¹, R² and R³ are each independently a monovalent cation, M is a divalent metal cation, X is a halogen anion, and n is an integer of 1 to 10.

8. The light absorption layer according to claim 7, wherein X is a fluorine anion, a chlorine anion, a bromine anion, or an iodine anion.

9. The light absorption layer according to claim 7 or 8, wherein R is one or more types selected from a cation of a first group element of the periodic table and an organic cation.

10. The light absorption layer according to any one of claims 7 to 9, wherein R¹, R², and R³ are one or more types selected from a cation of a first group element of the periodic table and an organic cation.

11. The light absorption layer according to any one of claims 7 to 10, wherein M is Pb²⁺, Sn²⁺, or Ge²⁺.

12. The light absorption layer according to any one of claims 1 to 11, wherein the aliphatic amino acid is a linear amino acid.

13. The light absorption layer according to any one of claims 1 to 12, wherein the aliphatic amino acid has 2 to 10 carbon atoms.

14. The light absorption layer according to any one of claims 1 to 13, wherein an amino group of the aliphatic amino acid is bonded to a primary carbon.

15. A dispersion comprising:
a perovskite compound or a precursor thereof; and
a quantum dot containing an aliphatic amino acid.

16. The dispersion according to claim 15, wherein the dispersion contains a solvent.

17. The dispersion according to claim 15 or 16, wherein a solid content concentration of the quantum dot in the dispersion is 10 mg/mL or more and 400 mg/mL or less.

18. A light absorption layer obtained from the dispersion according to any one of claims 15 to 17.

19. A method for manufacturing a light absorption layer in which a quantum dot containing an aliphatic amino acid is dispersed in a matrix of a perovskite compound, the method comprising following steps 1, 2, and 3:
(step 1) a step of exchanging an organic ligand of the quantum dot containing the organic ligand with an aliphatic amino acid to obtain a quantum dot solid containing an aliphatic amino acid as a ligand;
(step 2) a step of mixing the quantum dot solid obtained in step 1 with a solution or a mixed liquid containing one or more types of substances selected from a perovskite compound and a precursor thereof to obtain a dispersion; and
(step 3) a step of obtaining a light absorption layer from the dispersion obtained in step 2.

20. A photoelectric conversion element having the light absorption layer according to any one of claims 1 to 14, and 18.

21. A solar cell having the photoelectric conversion element according to claim 20.
